Europäisches Patentamt

European Patent Office

Office européen des brevets

(11) Publication number: **0 260 994 B1**

# EUROPEAN PATENT SPECIFICATION

(45) Date of publication of patent specification: **15.07.92**

(51) Int. Cl.5: **H01L 21/312**, H01L 21/306, H05K 3/28

(21) Application number: **87308303.4**

(22) Date of filing: **18.09.87**

(54) **Process for producing integrated circuit.**

(30) Priority: **18.09.86 JP 219945/86**
 **29.05.87 JP 134370/87**

(43) Date of publication of application:
 **23.03.88 Bulletin 88/12**

(45) Publication of the grant of the patent:
 **15.07.92 Bulletin 92/29**

(84) Designated Contracting States:
 **BE DE FR GB NL**

(56) References cited:
 **EP-A- 0 068 098**
 **EP-A- 0 211 667**
 **DD-A- 214 636**
 **DE-A- 2 424 367**
 **DE-A- 3 415 817**

 **PATENT ABSTRACTS OF JAPAN, vol. 9, no. 144 (P-365) (1867), 19 June 1985; & JP-A-60 24545**

 **PATENT ABSTRACTS OF JAPAN, vol. 9, no. 186, (P-377) (1909), 2 August 1985; & JP-A-60 57339**

(73) Proprietor: **JAPAN SYNTHETIC RUBBER CO., LTD.**
 **11-24, Tsukiji-2-chome Chuo-ku**
 **Tokyo 104(JP)**

(72) Inventor: **Okuda, Chozo**
 **Shofuryo, 1 Morigayamacho**
 **Yokkaichi-shi(JP)**
 Inventor: **Oka, Hiroshi**
 **Nihon Goseigomu Shataku 13-304 1 Morigayamacho**
 **Yokkaichi-shi(JP)**
 Inventor: **Miura, Takao**
 **22-6, Mitakidai-2-chome**
 **Yokkaichi-shi(JP)**

(74) Representative: **Clifford, Frederick Alan et al**
 **MARKS & CLERK 57/60 Lincoln's Inn Fields**
 **London WC2A 3LS(GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

This invention relates to a process for producing an integrated circuit. More particularly, this invention relates to a process for producing an integrated circuit comprising subjecting the back side of a substrate having a circuit on the front side to etching or grinding, characterized by using protective film for protecting the circuit on the front side.

In integrated circuit production, an integrated circuit is formed on one side of a semiconductor substrate such as a silicon wafer or the like; then the other side (back side) of the substrate is shaved by grinding or etching for the purposes of (a) removing impurities formed at the back side by ion implantation or the like and (b) thinning the substrate. At this time, the side of the substrate on which an integrated circuit has been formed is covered and protected with a protective film prior to the grinding or etching of the back side; and this protective film is peeled off after the grinding or etching.

In conventional processes for producing an integrated circuit, as a material for such a protective film, there has been used a negative resist consisting of a cyclized polyisoprene or the like, and a protective film has been formed by coating and then thermosetting the resist on the side of a semiconductor substrate having an integrated circuit according to an ordinary method.

The protective film made of a negative resist consisting of a cyclized polyisoprene or the like which film is used in conventional processes for producing an integrated circuit, is difficult to peel from the substrate. Hence, the peeling of the protective film requires a peeling solution containing an organic solvent of a high toxicity such as a phenol or a chlorinated hydrocarbon. Such an organic solvent cannot be removed from the substrate by water-washing and hence, a rinsing step of treating the substrate with a rinsing solution consisting of trichlene or the like is required. Therefore, the conventional processes are defective in that they comprise many steps and complicated operations. Moreover, the peeling solution and rinsing solution employed therein comprise highly toxic organic solvents; accordingly, the disposal of the waste solutions is not easy in the conventional processes.

The object of this invention is to provide a process for producing an integrated circuit in which a protective film is used which can be peeled with a peeling solution of a low toxicity, requires no rinsing step after the peeling and has high etching resistance.

The present inventors have found that the above-mentioned object can be achieved by using a protective film consisting of a novolac resin.

According to this invention, there is provided a process for producing an integrated circuit which comprises forming an integrated circuit on one side of a substrate, then coating the integrated circuit side with a protective film consisting of a novolac resin, and subjecting the opposite side of the substrate to etching or grinding and then removing the protective film.

As the substrate used in the present process, there is usually used a semiconductor substrate consisting of silicon, gallium, arsenic or the like. An integrated circuit is formed on the substrate according to a conventional method. In the case of, for example, a silicon planar transistor, an integrated circuit is formed by the following steps:

(1) Thermal oxidation of a silicon wafer
(2) Etching isolation-diffusion portion
(3) Isolation diffusion
(4) Etching base-diffusion portion
(5) Base diffusion
(6) Etching emitter-diffusion portion in base area
(7) Emitter-diffusion
(8) Perforating emitter area, base area and collector area for electrode contact
(9) Vapor deposition of material for circuit
(10) Etching unnecessarily deposited surface, and the like.

The subsequent formation of a novolac resin protective film on the integrated circuit side of the substrate is effected by spin-coating a solution of a novloac resin in an appropriate solvent, for example, a spinner and then baking the coating film on a hot plate or in a clean oven to remove the solvent.

The novolac resin used in this invention for the formation of a protective film is not critical though it is preferred for the resin to have a polystyrene-reduced weight-average molecular weight of at least 1,000 as measured by a gel permeation chromatography (GPC). When the weight-average molecular weight is less than 1,000, the resulting novolac resin solution has an inferior coatability and an offensive odor of, for example, the starting monomers for the novolac resin is generated in baking the coating film of the novolac resin solution. The upper limit of the polystyrene-reduced weight-average molecular weight of the novolac resin is ordinarily 30,000 though it may be as large as about 50,000 unless a gel is formed.

The novolac resin used in this invention can be produced according to a conventional method wherein a phenol and an aldehyde are subjected to addition condensation in the presence of an acid catalyst.

The phenol used in production of a novolac resin includes, for example, phenol, o-cresol, m-cresol, p-cresol, o-ethylphenol, m-ethylphenol, p-ethylphenol, o-butylphenol, m-butylphenol, p-butylphenol, 2,3-xylenol, 2,4-xylenol, 2,5-xylenol, 3,4-xylenol, 3,5-xylenol, 2,3,5-trimethylphenol, p-phenylphenol, hydroquinone, catechol, resorcinol, 2-methylresorcinol, pyrogallol, α-naphthol, bisphenol A, dihydroxybenzoic acid esters, gallic acid esters, etc. Among these compounds, preferred are phenol, o-cresol, m-cresol, p-cresol, 2,5-xylenol, 3,5-xylenol, 2,3,5-trimethylphenol, resorcinol, 2-methylresorcinol and bisphenol A. These phenols can be used alone or in admixture of two or more.

The aldehyde includes, for example, formaldehyde, paraformaldehyde, acetaldehyde, propylaldehyde, benzaldehyde, phenylacetaldehyde, α-phenylpropylaldehyde, 8-phenylpropylaldehyde, o-hydroxybenzaldehyde, m-hydroxybenzaldehyde, p-hydroxybenzaldehyde, o-chlorobenzaldehyde, m-chlorobenzaldehyde, p-chlorobenzaldehyde, o-nitrobenzaldehyde, m-nitrobenzaldehyde, p-nitrobenzaldehyde, o-methylbenzaldehyde, m-methylbenzaldehyde, p-methylbenzaldehyde, p-ethylbenzaldehyde, p-n-butylbenzaldehyde, etc. Among these compounds, preferred are formaldehyde, acetaldehyde and benzaldehyde. These aldehydes can be used alone or in admixture of two or more.

The aldehyde is used in an amount of preferably 0.7 to 3 moles, more preferably 0.7 to 2 moles, per mole of the phenol.

As the acid catalyst, there are used inorganic acids such as hydrochloric acid, nitric acid, sulfuric acid and the like, as well as organic acids such as formic acid, oxalic acid, acetic acid and the like. The acid catalyst is used in an amount of preferably $1 \times 10^{-4}$ to $5 \times 10^{-1}$ mole per mole of the phenol.

Water is ordinarily used as a reaction medium in the condensation. However, the reaction medium may be a hydrophilic solvent when the phenol used is not dissolved in an aqueous solution of the aldehyde used to form a heterogeneous system at the start of the reaction.

The hydrophilic solvent includes, for example, alcohols such as methanol, ethanol, propanol, butanol and the like, as well as cyclic ethers such as tetrahydrofuran, dioxane and the like. The amount of the reaction medium used is preferably 20 to 1,000 parts by weight per 100 parts by weight of the starting materials.

The condensation temperature can be appropriately varied depending upon the reactivity of the starting materials but is preferably 10° to 200°C, more preferably 70° to 150°C.

After the completion of the condensation, in order to remove the unreacted materials, acid catalyst and reaction medium present in the reaction system, the system is heated generally to 130° to 230°C and subjected to vacuum distillation to remove volatile matters, whereby a novolac resin is recovered.

The organic solvent used in the preparation of a novolac resin solution used when forming a protective film according to the present process includes, for example, alcohols such as methanol, ethanol, propanol, cyclohexanol and the like; ketones such as acetone, methyl ethyl ketone, methyl isobutyl ketone and the like; ethylene glycol derivatives such as ethylene glycol, methyl cellosolve, ethyl cellosolve, methyl cellosolve acetate, ethyl cellosolve acetate and the like; diethylene glycol ethers such as diethylene glycol monomethyl ether, diethylene glycol monoethyl ether and the like; propylene glycol alkyl ether acetates such as propylene glycol methyl ether acetate, propylene glycol ethyl ether acetate, propylene glycol propyl ether acetate and the like; monooxycarboxylic acid esters such as methyl 2-hydroxypropionate, ethyl 2-hydroxypropionate, ethyl 2-hydroxy-2-methylpropionate, ethyl ethoxyacetate, ethyl hydroxyacetate, methyl 2-hydroxy-3-methylbutanate and the like; and carboxylic acid esters of 3-methyl-3-methoxybutanol such as 3-methyl-3-methoxybutyl acetate, 3-methyl-3-methoxybutyl propionate, 3-methyl-3-methoxybutyl butyrate and the like. The organic solvent is not restricted to these compounds and may be any organic solvent as long as it has a boiling point of, for example, 60° to 250°C, is normally liquid, and can dissolve a novolac resin. When the organic solvent has a boiling point of less than 60°C, the solvent is volatilized to adversely affect not only the safety but also the stability of the protective film material. When the organic solvent has a boiling point of more than 250°C, the solvent is difficult to remove in baking the coating film of the novolac resin solution. The organic solvents specifically mentioned above can be used alone or in admixture of two or more.

Of the above organic solvents, propylene glycol alkyl ether acetates, monooxymonocarboxylic acid esters and carboxylic acid esters of 3-methyl-3-methoxybutanol are particularly advantageous from the standpoint of low toxicity, and propylene glycol methyl ether acetate, propylene glycol ethyl ether acetate, ethyl 2-hydroxypropionate, 3-methyl-3-methoxybutyl acetate, 3-methyl-3-methoxybutyl propionate and 3-methyl-3-methoxybutyl butyrate are most preferable.

Therefore, the organic solvent used in the preparation of a novolac resin solution is preferably a solvent comprising 30 to 100% by weight, particularly 50 to 100% by weight of at least one solvent selected from the group consisting of propylene glycol alkyl ether acetates, monooxymonocarboxylic acid esters and carboxylic acid esters of 3-methyl-3-methoxybutanol. Most preferably, the organic solvent consists only of a solvent selected from the group consisting of propylene glycol alkyl ether acetates, monooxymonocarboxylic acid esters and carboxylic acid esters of 3-methyl-3-methoxybutanol. When the organic solvent comprises said solvent in an amount of less than 30% by weight, a toxicity problem is caused by other solvents also contained in the organic solvent.

The novolac resin solution has a viscosity at 25°C of preferably 20 to 600 cP, most preferably 20 to 400 cP. When a spin-coating is effected using a spinner, generally, the higher the viscosity of the resin solution, the thicker the coating film becomes if the revolution of the spinner is the same. When the novolac resin solution has a viscosity at 25°C of less than 20 cP, the resulting coating film is too thin and pin holes are easily formed in the protective film. If in this case, the revolution of the spinner is decreased, the coating film becomes thicker only at the ends of the substrate such as a wafer, and the resulting protective film after baking tends to be cracked. When the novolac resin solution has a viscosity at 25°C of more than 600 cP, the excessive novolac resin solution applied to the substrate by a spinner becomes hard owing to the volatilization of the solvent therefrom when it is removed by revolution from the substrate, and hence, strings of the novolac resin are formed at the ends of the substrate, namely, a so-called stringing phenomenon is caused, whereby contaminants remain on the substrate and cause a problem. Further, the novolac resin solution having a high viscosity tends to give a thick protective film; however, it is disadvantageous in that such a thick film tends to cause adhesion between the novolac resin and a support for the substrate to cause contamination of the substrate or the like.

In this invention, the novolac resin solution can contain additives such as a surfactant for improving the coating property such as striation or the like.

The surfactant includes nonionic surfactants such as polyoxyethylene alkyl ethers (e.g. polyoxyethylene lauryl ether, polyoxyethylene stearyl ether, polyoxyethylene oleyl ether and the like), polyoxyethylene alkylphenyl ethers (e.g. polyoxyethylene octylphenyl ether, polyoxyethylene nonylphenyl ether and the like) and polyethylene glycol difatty acid esters (e.g. polyethylene glycol dilaurate, polyethylene glycol distearate and the like); fluorine type surfactants such as F TOP EF 301, EF 303, EF 352 (products of Shin Akita Kasei K.K.), MEGAFAC F 171, F 173 (products of DAINIPPON INK & CHEMICALS, INC.), straight chain fluorine type surfactants having a fluorinated alkyl group or a perfluoroalkyl group illustrated in Japanese Patent Application Kokai (Laid-Open) No. 178242/1982, FLUORAD FC 430, FC 431 (products of Sumitomo 3M K.K.), ASAHI GUARD AG 710, SURFLON S-382, SC 101, SC 102, SC 103, SC 104, SC 105, SC 106 (products of Asahi Glass Co., Ltd.); organosiloxane polymer KP 341 (product of Shin-Etsu Chemical Co., Ltd.); and acrylic and methacrylic acid type (co)-polymers POLYFLOW No. 75 and No. 95 (products of Kyoeisha Yushi Kagaku Kogyo K.K.).

These surfactants can be used alone or in admixture of two or more. The amount of the surfactant used is ordinarily 2 parts by weight or less, preferably 1 part by weight or less, per 100 parts by weight of the novolac resin.

In this invention, an integrated circuit is formed on one side of a substrate; then, a novolac resin solution is coated on the integrated circuit side and dried to form a protective film having a thickness of about 0.5 to 20 μm; subsequently, the opposite side (back side) of the substrate is shaved off. This shaving is conducted by (a) grinding, (b) immersion in an etchant such as hydrofluoric acid, nitric acid or the like, or (c) etching such as dry etching in a plasma etching apparatus.

After subjecting the back side of the substrate to grinding or etching, the protective film is peeled off from the substrate.

Peeling off the protective film from the substrate is conducted using a peeling solution. The peeling solution may be a solution of, for example, a lactam such as N-methyl-2-pyrrolidone, N-ethyl-2-pyrrolidone, N-propyl-2-pyrrolidone, N-hydroxymethyl-2-pyrrolidone, N-hydroxyethyl-2-pyrrolidone, N-hydroxypropyl-2-pyrrolidone, caprolactam or the like; an imidazoline such as 1,3-dimethyl-2-imidazolidinone, 1,3-diethyl-2-imidazolidinone, 1,3-diisopropyl-2-imidazolidinone, 1,3,4-trimethyl-2-imidazolidinone or the like; a morpholine such as morpholine, 4-methylmorpholine, 4-ethylmorpholine, 4-hydroxymethylmorpholine, 4-hydroxyethylmorpholine, 4-aminomethylmorpholine, 4-aminoethylmorpholine, 4-aminopropylmorpholine or the like; an amide; a sulfoxide; a sulfone; an amine; an aminoalcohol; a ketone; ethylene glycol or its derivative; diethylene glycol or its derivative; triethylene glycol ro its derivative; or an organic sulfonic acid. Among them, preferred are N-methyl-2-pyrrolidone, mospholine and diethylene glycol monoethyl ether. These compounds can be used alone or in admixture of two or more.

In this invention, the protective film can be completely removed simply by immersing the substrate in the above peeling solution for, e.g., 0.5 to 15 minutes and then water-washing the same. Moreover, the peeling solution mentioned above has a relatively low toxicity, is high in working safety and causes substantially no problem in waste disposal.

According to the present process for producing an integrated circuit, the integrated circuit side of the substrate can be satisfactorily protected by an improved protective film when the opposite side (back side) of the substrate is subjected to grinding or etching. Moreover, the protective film can be easily removed using a peeling solution of a low toxicity and the subsequent washing of the substrate can be conducted only with water, so that no rinsing step is required. Hence, the present process for producing an integrated circuit is advantageous in making the integrated circuit production efficient and simple and also in easy disposal of the peeling solution used.

This invention will be specifically explained below referring to Examples. However, these Examples are by way of illustration and not by way of restriction.

Preparation Example 1

In a 5-liter separable flask equipped with a stirrer, a condenser and a thermometer were placed 324 g (3 moles) of m-cresol, 216 g (2 moles) of p-cresol, 385 g of 37% by weight aqueous formaldehyde solution (4.75 moles of formaldehyde) and 0.4 g of oxalic acid. The separable flask was immersed in an oil bath, and the resulting mixture was subjected to reaction at 100°C for 6 hours.

The temperature of the oil bath was elevated to 180°C and simultaneously the interior of flask was evacuated to remove water, unreacted formaldehyde, unreacted m-cresol, unreacted p-cresol and oxalic acid, whereby a novolac resin was obtained.

The novolac resin was measured for a polystyrene-reduced weight-average molecular weight by a gel permeation chromatography wherein GPC column (two G2000H6 columns, one G3000H6 column and one G4000H6 column) manufactured by TOYO SODA MFG. CO., LTD. were used and tetrahydrofuran was used as an eluent. The molecular weight was 8,000.

In 60 parts by weight of ethyl cellosolve acetate was dissolved 40 parts by weight of the novolac resin to form a novolac resin solution. The solution had a viscosity of 320 cP at 25°C as measured by means of an E type viscometer manufactured by TOKYO KEIKI CO., LTD.

Preparation Example 2

A novolac resin having a polystyrene-reduced weight-average molecular weight of 4,000 as measured by GPC was obtained in the same manner as in Preparation Example 1, except that the reaction time was changed to 4 hours.

In 60 parts by weight of ethyl cellosolve acetate was dissolved 40 parts by weight of the novolac resin in the same manner as in Preparation Example 1, to prepare a novolac resin solution having a viscosity of 120 cP at 25°C.

Preparation Example 3

A novolac resin having a polystyrene-reduced weight-average molecular weight of 11,000 as measured by GPC was obtained in the same manner as in Preparation Example 1, except that the reaction time was changed to 7 hours.

In 60 parts by weight of ethyl cellosolve acetate was dissolved 40 parts by weight of the novolac resin in the same manner as in Preparation Example 1, to prepare a novolac resin solution having a viscosity of 400 cP at 25°C.

Preparation Example 4

In a 5-liter separable flask equipped with a stirrer, a condenser and a thermometer were placed 324 g (3 moles) of m-cresol, 244 g (2 moles) of 3,5-dimethylphenol, 385 g of 37% by weight aqueous formaldehyde solution (4.75 moles of formaldehyde) and 0.4 g of oxalic acid. The separable flask was immersed in an oil bath and the resulting mixture was subjected to reaction at 100°C for 2 hours. Then, the temperature of the oil bath was elevated to 180°C and simultaneously the interior of the flask was evacuated to remove water, unreacted formaldehyde, unreacted m-cresol, unreacted 3,5-dimethylphenol and oxalic acid, thereby obtaining a novolac resin. This novolac resin had a polystyrene-reduced weight-average molecular weight of 9,500 as measured in the same manner as in Preparation Example 1.

In 60 parts by weight of ethyl cellosolve acetate was dissolved 40 parts by weight of the novolac resin in the same manner as in Preparation Example 1, to prepare a novolac resin solution having a viscosity of 380 cP at 25°C.

Preparation Example 5

In 68.5 parts by weight of ethyl cellosolve acetate was dissolved 31.5 parts by weight of the novolac resin synthesized in Preparation Example 1, to prepare a novolac resin solution having a viscosity of 70 cP at 25°C.

Preparation Example 6

In 67.5 parts by weight of ethyl cellosolve acetate was dissolved 32.5 parts by weight of the novolac resin synthesized in Preparation Example 1, to prepare a novolac resin solution having a viscosity of 100 cP at 25°C.

Preparation Example 7

In 64 parts by weight of propylene glycol methyl ether acetate was dissolved 36 parts by weight of the novolac resin synthesized in Preparation Example 1, to prepare a novolac resin solution having a viscosity of 300 cP at 25°C.

Preparation Example 8

40 parts by weight of the novolac resin synthesized in Preparation Example 2 was dissolved in 60 parts by weight of propylene glycol methyl ether acetate in the same manner as in Preparation Example 1, to prepare a novolac resin solution having a viscosity of 135 cP at 25°C.

Preparation Example 9

36 parts by weight of the novolac resin synthesized in Preparation Example 3 was dissolved in 64 parts by weight of propylene glycol methyl ether acetate in the same manner as in Preparation Example 1, to prepare a novolac resin solution having a viscosity of 330 cP at 25°C.

Preparation Example 10

36 parts by weight of the novolac resin synthesized in Preparation Example 4 was dissolved in 64 parts by weight of propylene glycol methyl ether acetate in the same manner as in Preparation Example 1, to prepare a novolac resin solution having a viscosity of 350 cP at 25°C.

Preparation Example 11

26.5 parts by weight of the novolac resin synthesized in Preparation Example 1 was dissolved in 73.5 parts by weight of propylene glycol methyl ether acetate in the same manner as in Preparation Example 1, to prepare a novolac resin solution having a viscosity of 35 cP at 25°C.

Preparation Example 12

27.5 parts by weight of the novolac resin synthesized in Preparation Example 1 was dissolved in 72.5 parts by weight of propylene glycol methyl ether acetate in the same manner as in Preparation Example 1, to prepare a novolac resin solution having a viscosity of 65 cP at 25°C.

Preparation Example 13

32 parts by weight of the novolac resin synthesized in Preparation Example 4 was dissolved in 68 parts by weight of ethyl 2-hydroxypropionate in the same manner as in Preparation Example 1, to prepare a novolac resin solution having a viscosity of 220 cP at 25°C.

Example 1

Each of the novolac resin solutions obtained in Preparation Examples 1-4, 7, 9, 10 and 13 was filtered through a filter having a pore size of 0.2 $\mu$m to remove fine particles. The thus filtered novolac resin solution was spin-coated on the integrated circuit side of a silicon wafer by means of a spinner according to an ordinary method. Then, the coated wafer was baked at 150°C for 2 minutes on a hot plate to form a protective film having a thickness (as dried) of 7.5 $\mu$m.

Subsequently, the silicon wafer having a protective film on the integrated circuit side was immersed in an etching solution consisting of 49% by weight fluoric acid, 70% by weight nitric acid and water (1/20/5 by weight) at 20°C for 1 minute. The wafer having the protective film was taken out of the etching solution, thereafter washed with water and then observed through a microscope. As a result, none of the wafers showed any damage of protective film.

Each of the above silicon wafers having a protective film was immersed in N-methyl-2-pyrrolidone at 25°C for 1 minute, taken out thereof, and then washed with water for 20 seconds, whereby the protective film was completely peeled off in all cases. After the peeling, the silicon wafer having formed thereon an integrated circuit was observed through a microscope, to find that the surface of the wafer which had been covered with the protective film was quite the same as before the coating, namely left as it had been. Thus, the protective film exhibited an excellent protective property.

Example 2

In the same manner as in Example 1, the novolac resin solution obtained in Preparation Example 11 was filtered; the filtered solution was spin-coated on a silicon wafer; and the coated wafer was baked to form a protective film having a thickness (as dried) of 1.5 $\mu$m.

The properties of the protective film were examined in the same manner as in Example 1. The film exhibited the same protective property and peeling property as in Example 1.

Example 3

In the same manner as in Example 1, each of the novolac resin solutions obtained in Preparation Examples 5, 6, 8 and 12 was filtered; the filtered solution was spin-coated on a silicon wafer; and the coated wafer was baked to form a protective film having a thickness (as dried) of 3.0 $\mu$m.

The properties of the protective film were examined in the same manner as in Example 1. In each case, the film exhibited the same protective property and peeling property as in Example 1.

Comparative Example 1

A protective film having a thickness (as dried) of 2.0 $\mu$m was formed on a silicon wafer in the same manner as in Example 1, except that a negative resist JSR CIR 709 (a brand name of Japan Synthetic Rubber Co., Ltd.) was used in place of the novolac resin solutions. In the same manner as in Example 1, the protective film was examined for etching resistance, peeling property and protective property. The film had a good etching resistance but could not be peeled by peeling solution of a low toxicity such as a peeling solution of N-methyl-2-pyrrolidone.

**Claims**

1. A process for producing an integrated circuit, which comprises the steps of forming an integrated circuit on one side of a substrate, then coating the integrated circuit side with a protective film, subjecting the opposite side of the substrate to etching or grinding, and subsequently removing the protective film characterised in that the protective film consists of a novolac resin.

2. A process according to Claim 1, wherein the coating of the integrated circuit side with a protective film consisting of a novolac resin is conducted by applying to said side a solution of a novolac resin in an organic solvent and drying the solution to form a protective film having a thickness of 0.5 to 20 $\mu$m.

3. A process according to Claim 2, wherein the novolac resin has a polystyrene-reduced weight average molecular weight of at least 1,000 as measured by a gel permeation chromatography.

4. A process according to Claim 2 or 3, wherein the novolac resin is obtained by addition-condensing 1 mole of a phenol with 0.7 to 3 moles of an aldehyde at a temperature of 10° to 200°C in the presence of an acid catalyst.

5. A process according to Claim 4, wherein the phenol is at least one member selected from the group consisting of phenol, o-cresol, m-cresol, p-cresol, 2,5-xylenol, 3,5-xylenol, 2,3,5-trimethylphenol, resorcinol, 2-methylresorcinol and bisphenol A and the aldehyde is at least one member selected from the group consisting of formaldehyde, acetaldehyde and benzaldehyde.

6. A process according to Claim 2, 3, 4 or 5 wherein the solution of a novolac resin in an organic solvent has a viscosity of 20 to 600 cP at 25°C.

7. A process according to claim 2, 3, 4,5 or 6 wherein the organic solvent comprises at least one member selected from the group consisting of alcohols, ketones, ethylene glycols, diethylene glycols, propylene glycol alkyl ether acetates, monooxymonocarboxylic acid esters and carboxylic acid esters of 3-methyl-3-methoxybutanol.

8. A process according to Claim 2,3, 4,5, 6 or 7 wherein the organic solvent comprises 30 to 100% by weight of at least one member selected from the group consisting of propylene glycol alkyl ether acetates, monooxymonocarboxylic acid esters and carboxylic acid esters of 3-methyl-3-methoxybutanol.

9. A process according to Claim 8, wherein the organic solvent consists only of one member selected from the group consisting of propylene glycol alkyl ether acetates, monooxymonocarboxylic acid esters and carboxylic acid esters of 3-methyl-3-methoxybutanol.

10. A process according to Claim 8, wherein the organic solvent is at least one member selected from the group consisting of propylene glycol methyl ether acetate, propylene glycol ethyl ether acetate, ethyl 2-hydroxypropionate, 3-methyl-3-methoxybutyl acetate, 3-methyl-3-methoxybutyl propionate, and 3-methyl-3-methoxybutyl butyrate.

**Revendications**

1. Procédé de fabrication d'un circuit intégré, selon lequel on forme un circuit intégré sur une face d'un substrat, on revêt ensuite la face comportant le circuit intégré, avec un film protecteur, on soumet la face opposée du substrat à un décapage ou un meulage, et on élimine ensuite le film protecteur, caractérisé en ce que le film protecteur consiste en une résine Novolaque.

2. Procédé selon la revendication 1, dans lequel le revêtement de la face comportant le circuit intégré, avec un film protecteur consistant en une résine Novolaque, est effectué en appliquant sur ladite face, une solution d'une résine Novolaque dans un solvant organique, et en séchant la solution pour former un film protecteur ayant une épaisseur de 0,5 à 20 μm.

3. Procédé selon la revendication 2, dans lequel la résine Novolaque a un poids moléculaire moyen en poids réduit par rapport au polystyrène, d'au moins 1 000 d'après mesure par chromatographie par perméation de gel.

4. Procédé selon la revendication 2 ou 3, dans lequel la résine Novolaque est obtenue par condensation avec addition d'une mole d'un phénol, avec de 0,7 à 3 moles d'un aldéhyde, à une température de 10 à 200 °C, en présence d'un catalyseur acide.

5. Procédé selon la revendication 4, dans lequel le phénol comprend au moins un composé choisi parmi le phénol, l'o-crésol, le m-crésol, le p-crésol, le 2,5-xylénol, le 3,5-xylénol, le 2,3,5-triméthylphénol, le résorcinol, le 2-méthylrésorcinol, et le bisphénol A et dans lequel l'aldéhyde comprend au moins un composé choisi parmi le formaldéhyde, l'acétaldéhyde et le benzaldéhyde.

6. Procédé selon la revendication 2, 3, 4 ou 5, dans lequel la solution de résine Novolaque dans un solvant organique, a une viscosité de 20 à 600 cP à 25 °C.

7. Procédé selon la revendication 2, 3, 4, 5 ou 6, dans lequel le solvant organique comprend au moins un composé choisi parmi les alcools, les cétones, les éthylène glycols, les diéthylène glycols, les propylène glycol alkyl éther acétates, les esters d'acide monooxymonocarboxylique et les esters d'acide carboxylique dérivés du 3-méthyl-3-méthoxybutanol.

8. Procédé selon la revendication 2, 3, 4, 5, 6 ou 7, dans lequel le solvant organique comprend de 30 à 100 % en poids d'au moins un composé choisi parmi les propylène glycol alkyl éther acétates, les esters d'acide monooxymonocarboxylique et les esters d'acide carboxylique dérivés du 3-méthyl-3-méthoxybutanol.

9. Procédé selon la revendication 8, dans lequel le solvant organique consiste seulement en un composé choisi parmi les propylène glycol alkyl éther acétates, les esters d'acide monooxymonocarboxylique et les esters d'acide carboxylique dérivés du 3-méthyl-3-méthoxybutanol.

10. Procédé selon la revendication 8, dans lequel le solvant organique comprend au moins un composé choisi parmi le propylène glycol méthyl éther acétate, le propylène glycol éthyl éther acétate, le 2-hydroxypropionate d'éthyle, l'acétate de 3-méthyl-3-méthoxybutyle, le propionate de 3-méthyl-3-méthoxybutyle et le butyrate de 3-méthyl-3-méthoxybutyle.

**Patentansprüche**

1. Verfahren zur Herstellung eines integrierten Schaltkreises, das die folgenden Schritte umfaßt:
Bildung eines integrierten Schaltkreises auf einer Seite eines Substrats,
Beschichten der Seite mit dem integrierten Schaltkreis mit einer Schutzschicht,
Ätzen oder Schleifen der gegenüberliegenden Seite des Substrats
und anschließend
Entfernen der Schutzschicht,
**dadurch gekennzeichnet,** daß
die Schutzschicht aus einem Novolak-Harz besteht.

2. Verfahren nach Anspruch 1, worin die Beschichtung der Seite mit dem integrierten Schaltkreis mit einer aus einem Novolak-Harz bestehenden Schutzschicht durch Aufbringen einer Lösung eines Novolak-Harzes in einem organischen Lösungsmittel auf diese Seite und Trocknen der Lösung zur Bildung einer Schutzschicht mit einer Dicke von 0,5 bis 20 μm besteht.

3. Verfahren nach Anspruch 2, worin das Novolak-Harz eine polystyrolbezogene mittlere Molekülmasse von mindestens 1000, gemessen mit Gelpermeationschromatographie, besitzt.

4. Verfahren nach Anspruch 2 oder 3, worin das Novolak-Harz durch Addition-Kondensation von 1 mol eines Phenols mit 0,7 bis 3 mol eines Aldehyds bei einer Temperatur von 10 bis 200 °C in Gegenwart eines sauren Katalysators erhalten ist.

5. Verfahren nach Anspruch 4, worin das Phenol mindestens eine der folgenden Verbindungen ist: Phenol, o-Cresol, m-Cresol, p-Cresol, 2,5-Xylenol, 3,5-Xylenol, 2,3,5-Trimethylphenol, Resorcinol, 2-Methylresorcinol und Bisphenol A, und der Aldehyd mindestens eine der folgenden Verbindungen ist: Formaldehyd, Acetaldehyd und Benzaldehyd.

6. Verfahren nach den Ansprüchen 2, 3, 4 oder 5, worin die Lösung eines Novolak-Harzes in einem organischen Lösungsmittel eine Viskosität von 20 bis 600 cP bei 25 ° C besitzt.

7. Verfahren nach den Ansprüchen 2, 3, 4, 5 oder 6, worin das organische Lösungsmittel mindestens eine der Verbindungen ist: Alkohole, Ketone, Ethylenglycole, Diethylenglycole, Propylenglycolalkyletheracetate, Monohydroxymonocarbonsäureester und Carbonsäureester von 3-Methyl-3-methoxybutanol.

8. Verfahren nach den Ansprüchen 2, 3, 4, 5, 6 oder 7, worin das organische Lösungsmittel 30 bis 100 Gew.-% mindestens einer der folgenden Verbindungen enthält: Propylenglycolalkyletheracetate, Monohydroxymonocarbonsäureester und Carbonsäureester von 3-Methyl-3-methoxy-butanol.

9. Verfahren nach Anspruch 8, worin das organische Lösungsmittel aus nur einer der folgenden Verbindungen besteht: Propylenglycolalkyletheracetate, Monohydroxymonocarbonsäureester und Carbonsäureester von 3-Methyl-3-methoxybutanol.

10. Verfahren nach Anspruch 8, worin das organische Lösungsmittel mindestens eine der folgenden Verbindungen ist: Propylenglycolmethyletheracetat, Propylenglycolethyletheracetat, Ethyl-2-hydroxypropionat, 3-Methyl-3-methoxybutylacetat, 3-Methyl-3-methoxybutylpropionat und 3-Methyl-3-methoxybutylbutyrat.